# EUROPEAN PATENT SPECIFICATION

(11) **EP 3 714 489 B1**
(45) Date of publication and mention of the grant of the patent: **02.09.2026**
(21) Application number: 18830014.9
(22) Date of filing: 22.11.2018
(51) Int. Cl.: H10D 30/01, H10D 30/63, H10D 62/85

(54) **VERTICAL GAN TRANSISTOR WITH INSULATING CHANNEL AND THE METHOD OF FORMING THE SAME**
VERTIKALER GAN-TRANSISTOR MIT ISOLIERENDEM KANAL UND VERFAHREN ZU DESSEN HERSTELLUNG
TRANSISTOR À GAN VERTICAL AYANT UN CANAL ISOLANT ET SON PROCÉDÉ DE FORMATION

(30) Priority: 24.11.2017 SK 500742017
(43) Date of publication of application: 30.09.2020
(60) Divisional application: 26195341.8
(73) Proprietor: Elektrotechnicky Ústav Sav, 841 04 Bratislava (SK)
(72) Inventor: KUZMÍK, Ján, 811 05 Bratislava (SK)
(74) Representative: Porubcan, Róbert
(86) International application number: PCT/SK2018/000009
(87) International publication number: WO 2019/103698

(56) References cited:
- WO-A1-2016/168511
- US-A1- 2009 230 433
- US-A1- 2012 025 169
- US-A1- 2017 194 478
- HIROTAKA OTAKE ET AL: "Vertical GaN-based trench gate metal oxide semiconductor field-effect transistors on GaN bulk substrates", APPLIED PHYSICS EXPRESS, JAPAN SOCIETY OF APPLIED PHYSICS; JP, JP, vol. 1, no. 1, 1 January 2008 (2008-01-01), pages 11105-1 - 11105-3, XP001517070, ISSN: 1882-0778, DOI: 10.1143/APEX.1.011105

## Description

### Field of the invention

Invention relates to vertical GaN transistors with an insulating channel and the method of forming the same. In particular, it relates to manufacturing power and highfrequency transistors having a positive threshold voltage.

### Background Art

Securing ecological development of the society directly relates to creation of new methods of effective utilization of available energy sources. One option is represented by minimization of losses in electrical power converters. In order to maximize the power and minimalize losses by conversion, exploitation of semiconductor GaN-based power transistors is highly appropriate.

GaN is chemically inert material with energy band gap of 3.4 eV, which predestines applications in a hostile environment and elevated temperatures above 300 °C. Besides, a high saturation drift velocity of electrons in GaN around 1 x 105 m/s provides switching of transistors at high frequency. Mentioned material parameters are exceptionally suitable for constructing high power and frequency transistors and converters with high efficiency.

Generally attainable GaN-based transistors are prepared as planar unipolar field-effect transistors (FETs). Charge transport is running between the source and the drain electrodes through the GaN channel and is controlled by the gate. Basis is provided by an epitaxial structure grown on a mostly foreign substrate (silicon, sapphire, silicon carbide), or on the GaN substrate. Standard structure is made of the substrate, buffer insulating (SI) GaN layer, channel n GaN layer and the barrier AlGaN layer. Metal-organic chemical vapour deposition (MOCVD) or molecular-beam epitaxy (MBE) are mostly used as growth techniques. A channel n GaN layer should contain minimum dislocations and impurities, such as vacancies or carbon, so that to attain the highest mobility of charge carriers and the best conditions for the transistor switching, avoiding parasitic influence of deep levels. However in the case of MOCVD, carbon is present in growth precursors such as trimetylgalium (TMGa) and consequently, optimal growth conditions for the channel should be set in the way so that the inherent presence of carbon is minimized. Similarly, standard conditions of the growth cannot exclude presence of residual donor impurities, such as oxygen, and typically the concentration of free electrons in such un-intentionally doped GaN is in the range of 10¹⁶ cm⁻³. Channel n GaN layer is grown on so-called buffer insulating GaN layer, which should provide the optimal growth conditions by separating it from a defective GaN/substrate interface, while the thickness of the buffer layer is around 1 to 5 µm. Buffer insulating GaN layer serves also as the insulation layer, which provides high resistance of the transistor in the off-state and a high value of the breakdown voltage. Consequently, in comparison to the n GaN channel layer, the buffer GaN layer needs intentionally increased concentration or additional introduction of deep acceptor states such as carbon, iron, magnesium or Ga vacancies, which compensate residual donors. Consequently, such insulating GaN layer is sometime referred as semi-insulating (SI). For example, the content of carbon in the buffer insulating GaN layer grown by MOCVD is controlled by a specific setting of the growth temperature, pressure or gases flows. The channel n GaN layer is normally covered by about 20 to 50 nm-thick AlGaN barrier layer forming a two-dimensional electron gas (2DEG) at the interface to n GaN. In this way it is possible to secure channel conduction without distorting mobility by scattering on ionized impurities. To prevent injection of electrons from the 2DEG and its parasitic trapping in deep levels of the buffer insulating GaN layer, for the channel GaN layer it is vital to have sufficient thickness of e.g. 100 nm. Electron injection from the channel n GaN layer and its trapping in the buffer insulating GaN layer takes place mainly in the place of the highest intensity of electric field, which is a longitudinal region of the buffer insulating GaN layer between the gate and the drain electrodes. In this way, by electron trapping, an undesirable depletion of the channel n GaN layer along the whole specified region may appear as a consequence of electrostatic influence of the trapped charge. Consequently, the channel current drops, which is referred as a current collapse effect and the transistor switching is delayed, respectively. Thus the proposal of the content and doping of the GaN (hetero)structure is crucial for the device performance.

Plasma etching is used by device preparation, contact systems are evaporated through the mask prepared by photolithography and patterned by a lift-off technique. Gate electrode use to be isolated from the semiconductor by an oxide or dielectric insulating layer, by using a metal-oxide-semiconductor (MGS) or metal-insulator-semiconductor (MIS) structure, respectively. Distance between the gate and the drain electrodes is chosen sufficiently long, e.g. 10 µm, so that a required transistor breakdown strength is secured.

Apart from the electron trapping in the buffer insulating GaN layer, to most common problems of planar GaN transistors belong analogous electron trapping at surface states, lower breakdown voltage than its theoretical value, which also relates to specific geometry of the planar device and to properties of surface states, and also to enhanced self-healing due to limited heat dissipation from the device surface. Due to mentioned reasons, concept of the vertical transistor is used as an alternative solution for preparation of GaN power devices.

Vertical transistor is characterized by a charge transport in a vertical direction and by a GaN structure typically grown on the GaN substrate. Consequently, it is possible to minimize density of dislocations in the epitaxial structure as far as the growth is performed without strain at the interface with the substrate and also it is possible to minimize the device surface area because the drain electrode is located at the opposite side of the substrate in respect to the source electrode. In this way it possible to eliminate current collapse, increase the breakdown voltage of the device and also to improve the heat dissipation. According to M. Sun et.al., IEEE EDL38, (2017) 509, unipolar vertical transistor made of n-type semiconductors begins with highly doped contacting n+ GaN layer, followed by a drift n GaN layer where donor doping is around 10¹⁶ cm⁻³ and the thickness is several micrometres defying the breakdown voltage of the transistor, by the channel n GaN layer with similar concentration of donors defying the threshold voltage of the transistor and by the highly doped source n+ GaN layer, see also US 2015/0179772 A1 and US 2016/0308045 A1.

Threshold voltage of the transistor (V_{T}) is a value of the voltage applied on the gate electrode when the channel state is flipped (open/closed channel) as a consequence of an electrostatic influence of the gate. If V_{T}> 0 V, then for the channel made of free electrons we deal with the enhancement-mode transistor which is closed without applying voltage on the electrode of the gate. This type of transistor is exceptionally suitable for constructing power converters. In the opposite case we deal with the depletion-mode transistor. The higher is the density of donor impurities in the channel, the more negative is the V_{T} value. Thus for acquiring the enhancement-mode it is necessary to e.g. decrease concentration or exclude the presence of donors and/or reduce the thickness of the depletion region in the channel. Analogous situation appears also for the channel made of free holes.

Type of the semiconductor is given by the position of impurity atoms in the energy band structure of semiconductor (S. M. Sze and Kwok K, Ng, Physics of Semiconductor Devices, Third Edition, Wiley 2007). If the impurity energy level is dose to the semiconductor conduction band (E_{C}), ionized impurity provides free electrons, Fermi level (E_{F}) moves towards the conduction band and the semiconductor is n-type (n GaN). On the other hand, if the impurity energy level is close to the semiconductor valence band (E_{V}), ionization will lead to free holes generation, E_{F} will be close to E_{V} and the semiconductor is p-type (p GaN). Concentration of free charge carriers in both cases rises with the concentration of impurities and depends on the energy level of the impurity and ambient temperature. For the un-doped semiconductor, E_{F} is located around the middle of the energy gap and generation of free carriers is provided by the charge exchange between the valence and the conduction bands. This so called intrinsic concentration of free carriers is significantly lower than in the case of doped semiconductors. Following, particularly for semiconductors with the wide energy band gap, the un-doped semiconductor behaves like an insulator. However, insulating properties and localization of E_{F} around the middle of the energy gap can be obtained also for a specific ratio of concentrations of donor (N_{D}) and acceptor (N_{A}) impurities or defects. In that case charge exchange between ionized impurity levels dominates, which significantly reduces possibility of free charge carrier generation, and impurities and defects compensate each other, i.e. semiconductor is neither n-type, nor p-type. Semiconductor prepared in this way is an insulator and sometimes is also referred as semi-insulating (SI). In practice, in the case of GaN, residual donors (e.g. oxygen) are compensated by e.g. carbon impurities which generate acceptor levels. However, energy level of carbon is about 0.9 eV above the valence band of GaN, which is coupled with the long charge emission time constant and with mentioned undesired parasitic effects of the current collapse and delayed switching. Concentration ratio of acceptors and donors NA/NO determines so-called compensation ratio and for reaching a maximal elimination of free charges it is necessary to take into account several factors, such as position of acceptor and donor levels in the energy diagram and the charge at these energy-levels. For example, for compensating GaN by C, N_{A}/N_{D} > 1 applies and thus for the growth of SI GaN, high concentration of C is generally needed. Unipolar devices are those where either electrons or holes are used for the charge transport. Usage of only one type of semiconductor simplifies proposal and preparation of GaN transistors.

State-of-the-art solutions of enhancement-mode unipolar vertical GaN transistors possess following drawbacks and limitations:
Vertical transistors after M. Sun et.al., IEEE EDL 38, (2017) 509, and also after US 2015/0179772 A1 or US 2016/0308045 A1 are unipolar devices with defined n- or p-type channel conduction, with impurity concentration of at least 10¹³ cm⁻³. From aforementioned follows that for obtaining the transistor enhancement-mode it is necessary to decrease the thickness of the depleting region of the channel down-to maximally 10 pm, but practically down-to sub-µm dimensions. This is possible only by using complex steps, such as a nano-patterning and electron-beam lithography. Similarly, for achieving higher currents it is necessary to use a parallel combination of several vertical channels, with interconnects between individual source electrodes, which require mastering additional difficult technological steps, such as self-aligned contacts and airbridge connections, see US 2015/0179772 A1 or US 2016/0308045 A1.

Publication Hirotaka Otake et al "Vertical GaN-Based Trench Gate Metal Oxide Semiconductor Field-Effect Transistors on GaN Bulk Substrates"; Applied Physics Express 1 011105, describes vertical trench gate metal oxide semiconductor field-effect transistors (MOSFETs), which have been produced using gallium nitride (GaN).

Publication US2012025169A1 disclosed transistors and methods for forming transistors from groups of nanostructures. The transistor may be formed from an array of nanostructures that are grown vertically on a substrate. The nanostructures may have lower, middle and upper segments that may be formed with different materials and/or doping to achieve desired effects. Collectively, the lower segments may form the source or drain, with the middle segments collectively forming the channel.

### Disclosure of the Invention

The invention is as defined in claims 1 to 4.

Drawbacks of the state-of-the-art solutions are eliminated by the invention of the unipolar vertical GaN transistor with the insulating GaN channel and a positive threshold voltage. This type of the enhancement-mode transistor is grown on the conductive GaN substrate and comprises, from the bottom, a drift n GaN layer, a channel insulating GaN layer, and a highly doped contacting n⁺ GaN layer. Insulating properties of the channel insulating GaN layer are provided by compensating residual donors in the GaN layer by intentional addition/increase of the concentration of deep acceptor impurity or defects. Insulating character of the channel GaN layer secures transistor enhancement-mode and also facilitates robust construction of the transistor, without a need for nano-patterning, parallel combination of several channels and airbridge connection of source electrodes.

Usage of the channel insulating GaN layer may seem counter-productive and was never used in GaN transistors before as deep acceptor levels degrade electron mobility and cause its trapping, leading to parasitic effects such as the current collapse and delayed switching. However in the proposed vertical transistor, in comparison to planar transistors, the region between the channel insulating GaN layer and the electrode of the drain is exclusively made of n-type semiconductor which significantly reduces possibilities of electron trapping. Moreover, in the on-state, intimate connection of the channel insulating GaN layer with the drift n GaN layer will cause effective pulling of electrons from the channel insulating GaN layer by the perpendicular electric field. Generally, high electron mobility in layers grown on the GaN substrate can be expected, which may be partially deteriorated only in the case of increased concentration of compensating levels. However, for the current density in short channel transistor the electron saturation velocity is crucial, what is a GaN material parameter only partially linked to the electron mobility.

### Brief Description of Drawings

Figure 1 shows scheme of the enhancement-mode vertical GaN transistor with the channel insulating GaN layer.
Figure 2 shows setting of the distance between vertical walls of the channel insulating GaN layer by RIE etching of the mesa region.
Figure 3 shows forming of the electrode of the source by using lithography after the RIE etching.
Figure 4 shows forming of the resist mask of the electrode of the gate.
Figure 5 shows top view of the electrode of the source and lead out of the contacting pad of the electrode of the gate.
Figure 6 shows calculated output characteristics of the vertical GaN transistor shown in Figure 1 with 400 µm-wide channel.
Figure 7 shows course of the energy band diagram in the channel insulating GaN layer along the distance from the surface of the dielectric insulating layer for different concentrations of free electrons.
Figure 8 shows course of the energy band diagram and concentration of free electrons in the channel insulating GaN layer along the distance from the surface of the dielectric insulating layer for a different bias on the electrode of the gate.

### Best Mode for Carrying out the Invention

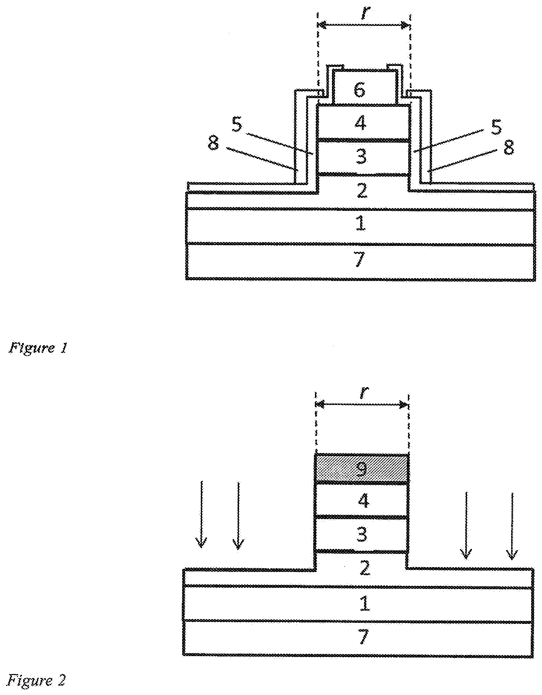

Figure 1 shows scheme of the enhancement-mode unipolar vertical GaN transistor comprising the conductive GaN substrate **1,** the doped drift n GaN layer **2,** the channel insulating GaN layer **3,** the doped contacting n⁺ GaN layer **4,** the dielectric insulating layer **5,** the electrode **6** of the source, the electrode **7** of the drain and the electrode **8** of the gate. Distance between vertical walls of the channel insulating GaN layer **3** and the width of the contacting n⁺ GaN layer 4 is labelled as r.

Epitaxial growth of GaN layers is performed by e.g. technique of MBE or MOCVD on the conductive GaN substrate with the surface prepared for the epitaxial growth. In the case of MBE, GaN is grown by using nitrogen plasma or in an ammonia environment, in the case of MOCVD TMGa and NH₃ are used as growth precursors and silane is a source of Si donors. Typically, thickness of the GaN substrate is about 300 µm, resistance is less than 25 mΩcm, and orientation of the substrate provides subsequent growth along c axes. Prior growth, surface of the GaN must be released from dirtiness and gaseous particles by e.g. heating in the growth chamber to temperature above 1000 °C. This is followed by the growth of the drift n GaN layer **2** doped with Si, in the way that the concentration of free electrons *n_{d}* and the thickness *d_{d}* fulfil inequalities *n_{d} < 2 V_{BR} ε*/ *q d_{d}²,* where *V_{BR}* is a required value of the breakdown voltage on the electrode of the drain and simultaneously *d_{d} > V_{BR}*/ *E_{crit}*, where *E_{crit} ~* 5 x 10⁶V/cm is the electrical strength of GaN. Following, for *V_{BR}* ~ hundreds to kV range, typically *n_{d}* is in the range of 10¹⁶ cm⁻³, however maximally up-to about 2 x10¹⁷ cm⁻³ and *d_{d}* is about 5 to 15 µm, however minimally about 3 µm. Alternatively, for large values of the residual concentration of free electrons, Si doping may be omitted. Next, growth of the channel insulating GaN layer **3** is performed. Thickness *L* of the channel insulating GaN layer **3** is e.g. 1 to 3 µm, however for the enhancement of the transistor switching speed, *L* can selected in the sub-µm range.

The n⁺ GaN contacting layer **4** is grown as the last one, where Si doping can be in the range of 10¹⁸ cm⁻³ and the thickness is about 0.2 to 1 µm. Setting of the distance between vertical walls of the channel insulating GaN layer **3** and of the n⁺ GaN contacting layer **4** respectively, is given by etching of the mesa regions with a characteristic distance *r*, see Figure 2. Etching is performed by using a reactive ion etching (RIE) through the resist mask **9,** in gasses based on e.g. SiCl₄. Providing we choose circular geometry of the electrode **6** of the source and the thickness of the dielectric insulating layer **5** is neglected (see Figure 1), then for the perimeter *w* of the channel applies *w* = *πr.* Following, for *r* ~ 130 µm we get *w* ~ 400 µm. Such dimensions can be defined by using a conventional optical lithography, without a need for the electron-beam lithography or nano-patterning. Apart from that, sufficiently large area of the electrode **6** of the source facilities direct contacting of electrodes, without a need for contacting pad lead beyond the mesa region. We can also choose rectangle geometry of the electrode **6** of the source with side lengths of *w* and *r*. Depth of etching of the mesa region is selected in a way so that the drift layer **2** is reached, i.e. towards the depth of about 1.5 to 4 µm, depending on actual layers thicknesses.

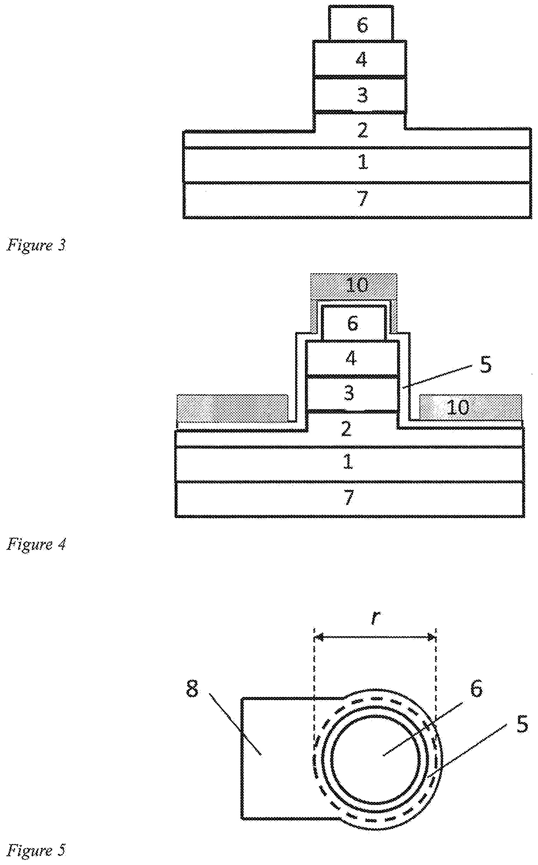

The etching is followed by own forming of the electrode **6** of the source, by repetitive usage of the optical lithography, see Figure 3. Dimensions of the electrode **6** of the source must secure sufficient tolerance towards the edge of the mesa region and also towards the edge of the following resist mask **10** of the electrode of the gate, see Figures 1, 3 and 4. After evaporating the system of the ohmic metallisation (e.g. Ti/Al/Ni/Au) and its patterning by the lift-off technique, a short thermal annealing is applied at about 850 °C. Growth of the dielectric insulating layer **5,** such as Al₂O₃, ZrO₂ or HfO₂ with a thickness of about 5 to 20 nm follows annealing before forming the resist mask 10. Growth is performed over the whole area of the device by using e.g. technique of the conformal atomic layer deposition (ALD). Dielectric insulating layer **5** has a broader width of the energy gap than GaN so that to suppress leakage currents through the electrode **8** of the gate even at a positive voltage bias *V_{G}* on the gate. After forming the resist mask **10** shown in Figure 4, deposition of metals on vertical walls of the channel insulating GaN layer **3** follows, with some overlap on the neighbour drift n GaN layer **2** and contacting n⁺ GaN layer **4.** Metals such as Ni and Au, or conducting oxides can be deposited by sputtering, by an angle evaporation from the electron gun, by an electroplating or by using ALD. Contacting pads of the electrode **8** of the gate can be lead out beyond the defined mesa region, see Figure 5. After forming the bottom electrode **7** of the drain it is possible to deposit the next contacting metallisation on selected areas of all electrodes, and to passivate the device by depositing e.g. protective Si₃N₄ layer.

The first embodiment.

After the first embodiment of the invention, residual donors in the channel insulating GaN layer 3 are compensated by adding or increasing the concentration of C. By using MBE, C is delivered from an external source, such as from e.g. ion gun. By using MOCVD for the growth of the insulating GaN layer it is also possible to use external source of C in a form of the organic precursor however, this is not necessarily needed as C is inherently present in organometallic precursors of the GaN growth alone, such as in TMGa. However it is necessary to set the parameters of the MOCVD in a way that the concentration of C exceeds conventional values of the residual concentration of C in un-intentionally doped n GaN layers. In practice it is possible to e.g. decrease the temperature of the growth by more than 100 °C from the optimal temperature of the GaN growth, for example down to 900 °C from 1080 °C, and/or to decrease the pressure up-to several times from the optimal value, eventually to decrease the NH₃ flow or increase the TMGa flow. N₂, H₂ or a mixture of them are used as a carrier gas, higher concentration of C can be reached by increasing H₂ flow. In this way it is possible to increase C concentration from the residual un-intentional level, e.g. from the range of 10¹⁶ cm⁻³ up-to 10¹⁸ cm⁻³.

The second embodiment.

After the second embodiment , which does not form part of the invention, residual donors in the channel insulating GaN layer 3 are compensated by adding Fe impurity. Fe can be added from the external source or from the precursor.

The third embodiment.

After the third embodiment, which does not form part of the invention, residual donors in the channel insulating GaN layer 3 are compensated by adding Mg impurity. Mg can be added from the external source or from the precursor.

The fourth embodiment.

After the fourth embodiment, which does not form part of the invention, residual donors in the channel insulating GaN layer 3 are compensated by increasing the concentration of Ga vacancies. Concentration of these defects can be increased by e.g. increasing the V/III molar ratio during the growth.

Following description of the operation of the invented transistor is based on the analytical model described in Lee K et.al., IEEE Transactions on Electron Devices, vol. ED-30, pages 207-212, 1983 and in Curtice W R, IEEE Transactions on Microwave Theory and Technology vol. 28, page 448, 1980, which is here modified for calculating current in the MOS FET transistor with the channel insulating GaN layer **3.** Following for *V_{T}* applies: ${V}_{T} = {Φ}_{Box} - Δ {E}_{C}$ where *Φ_{Box}* is the Schottky barrier height of the metal electrode **8** of the gate on the oxide or the dielectric insulating layer **5,** and Δ*E_{C}* is the band discontinuity at the oxide/GaN interface.

Saturation current between the electrode **6** of the source and the electrode **7** of the drain is given as: ${I}_{sat} = \left({βV}_{s}^{2}{\left(1+2{βR}_{s}V{′}_{G}+V{{′}_{G}}^{2}/{V}_{s}^{2}\right)}^{1 / 2}-\left(1+{βR}_{s}V{′}_{G}\right)\right) / \left(1-{β}^{2}{{R}_{s}}^{2}{V}_{s}^{2}\right)$ where *R_{S}* is a parasitic resistance of the source region, and $V {′}_{G} = {V}_{G} - {V}_{T}$ ${V}_{s} = {ν}_{s} L / μ$ $β = ε μ w / {d}_{EOT} L$ where *L* is the channel length which equals the thickness of the channel insulating GaN layer **3,** *ε* is the permittivity of the channel insulating GaN layer **3,** *d_{EOT}* is the equivalent thickness of the dielectric (oxide) insulating layer **5** in respect to *ε* and w is the width or perimeter of the channel given by the third dimension in the direction perpendicular to shown cross-section. For calculating the dependence of the drain current (*I_{DS}*) on the drain voltage (*V_{DS}*) we use a heuristic dependence: ${I}_{DS} = {I}_{sat} \left(1+{λV}_{DS}\right) tanh \left({ηV}_{DS}\right)$ where *η* is calculated as: $η = \left({qμn}_{si}/L\right) / \left({I}_{sat}\left(1+\left({R}_{S}+{R}_{D}\right)\left({qμn}_{si}/L\right)\right)\right)$ while ${n}_{si} = ε \left({V}_{G}-{I}_{sat}{R}_{S}-{V}_{T}\right) / {qd}_{EOT}$ where *q* is the electron charge, *R_{D}* is the parasitic resistance of the drain region and *λ* is a parameter of the output conductance. Effects of self-heating are not included in the model.

Calculation of output currents of the transistor is combined with calculation of the energy band structure by solving the Poisson-Schrödinger equation after Tan I H et.al., J. Appl. Phys. vol. 68, page 4071. 1990.

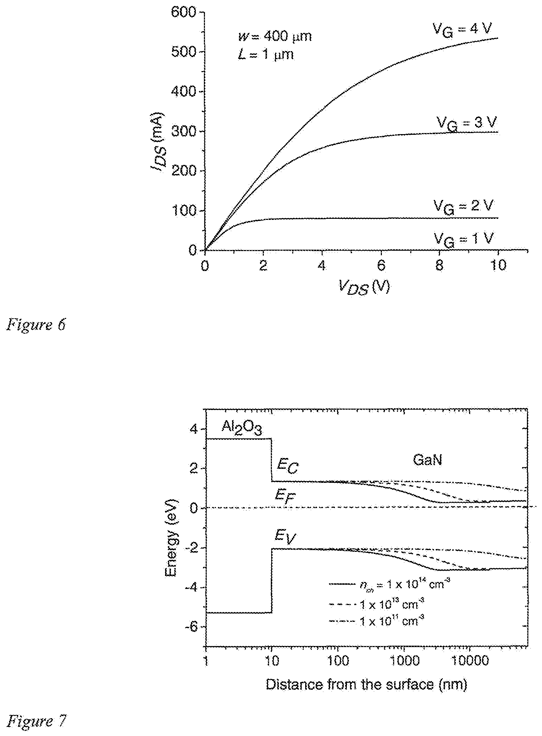

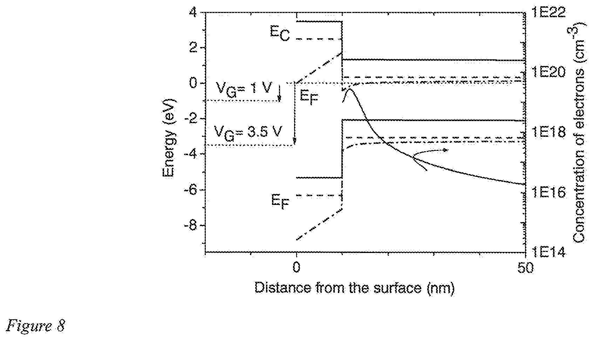

Figure 6 shows simulation of output characteristics of the enhancement-mode transistor which scheme is shown in Figure 1. Calculation assumes *L* =1 µm, w = 400 µm, *R_{S}* = 1 Ω, *R_{D}* = 10 Ω, *µ =* 1000 cm²/Vs. Higher value of *R_{D}* reflects requirement for the higher breakdown voltage of the transistor (hundreds or kV range), which defines the upper limit of the concentration of free carriers and a minimal thickness of the drift n GaN layer **2.** Usage of the 10 nm thick dielectric insulating layer **5** based on Al₂O₃ is considered, with the relative permittivity of 9, *Φ_{Box}* = 3.2 eV and Δ*E_{C}* = 2 eV. Attainable currents of 550 mA at *V_{G} =* 4 V point on appropriateness of the transistor for power applications. Moreover, advantage of the insulating character of the channel insulating GaN layer **3** is also by providing a robust construction of the upper electrode **6** of the source without decreasing the value of *V_{T}.* Figure 7 shows course of the energy band diagram in the channel of the transistor along the distance *r*, beginning from the surface of the dielectric insulating layer **5.** Calculation is shown for various values of the concentration of free electrons in the channel layer (*n_{ch}*), depletion only from the one side of the channel is considered. For *n_{ch}* = 1 x 10¹⁴ cm⁻³, bending of the band diagram is taking place already at the distance of 200 nm from the surface and the full shift of the conduction band towards the Fermi level appears at the distance of less than 3 µm. Obviously, for the un-intentionally doped n GaN layer where typical values of the residual concentration of electrons are in the range from 10¹⁵ to 10¹⁶ cm⁻³, *r* < 1 µm is needed for securing a positive *V_{T}* and low leakage currents. On the other hand, for e.g. C-doped channel insulating GaN layer **3** where *n_{ch} =* 1 x 10¹¹ cm⁻³, shift of the conduction band is taking place only at *r* > 70 µm. That value of *n_{ch}* in the GaN can be reached only by intentional acceptor doping and by compensating residual donors. For explanation of the enhancement-mode transistor prepared in this way, in Figure 8 we show energy band diagram and generation of free electrons in the channel insulating GaN layer **3** by applying a positive bias *V_{G}* on the electrode **8** of the gate. At *V_{G}* = 1 V, which is less than *V_{T},* band structure is vertically shifted without generating free carriers. On the other hand, conductive channel with *n_{ch}* > 2 x 10¹⁹ cm⁻³ is created at *V_{G}* = 3.5 V, which integrated sheet concentration is about 9 x 10¹⁶ m⁻².

From the above description of operation follows, that the invented vertical GaN transistor shown in Figure 1 facilitates robust geometry with *r ~* 130 µm without usage of complex nanotechnologies and the operation in the enhancement-mode.

### Industrial Applicability

Power enhancement-mode transistors with the insulating GaN channel layer will find applications in highly efficient converters of the electric power. Applications will be found by generation and distribution of electric power, and also by charging and in propulsion units of electric cars.

## Claims

1. Vertical GaN transistor with an insulating channel layer comprising from the bottom at least:
(a) a conductive GaN substrate (1);
(b) a drift n GaN layer (2) formed on the conductive GaN substrate (1);
(c) a cylindrical channel insulating GaN layer (3) formed on the drift n GaN layer (2), wherein residual donors are compensated by adding or increasing the concentration of carbon C, wherein the concentration of carbon impurities in the channel insulating GaN layer (3) is in the range of 10¹⁶ cm⁻³ up to 10¹⁸ cm⁻³,
(d) a contacting n+ GaN layer (4) formed on the channel insulating GaN layer (3); wherein an electrode (6) of the source is located on the top of the contacting n+ GaN layer (4), an electrode (7) of the drain is located at the backside of the GaN substrate (1), and an electrode (8) of the gate is located vertically along the channel insulating GaN layer (3) and is separated along its whole length from the contacting n+ GaN layer (4), the channel insulating layer (3) and the drift n GaN layer (2) by a dielectric insulating layer (5) with a wider energy gap than GaN.

2. The vertical GaN transistor with the insulating channel of claim 1, wherein the concentration of free electrons in the channel insulating layer is less or equal than 10¹¹ cm⁻³.

3. A method of forming of a vertical GaN transistor with an insulating channel layer, the method comprising sequentially at least:
(a) forming by growing a drift n GaN layer (2) on a conductive GaN substrate (1);
(b) forming by growing the cylindrical channel insulating GaN layer (3) wherein residual donors are compensated by adding or increasing the concentration of carbon C, whereby the concentration of carbon impurities in the channel insulating GaN layer (3) is in the range of 10¹⁶ cm⁻³ up to 10¹⁸ cm⁻³ to achieve a specific concentration of free electrons in the channel insulating GaN layer (3) after forming the drift n GaN layer (2);
(c) forming by growing a contacting n⁺ GaN layer (4), after forming the channel insulating layer (3); and from a consecutive forming of an electrode (6) of the source located on top of the formed contacting n⁺ GaN layer (4), an electrode (7) of the drain located at the backside of the GaN substrate (1), and of an electrode (8) of the gate located vertically along the formed channel insulating GaN layer (3) separated along its whole length from the contacting n⁺ GaN layer (4), the channel insulating layer (3) and the drift n GaN layer (2) by a dielectric insulating layer (5) with a wider energy gap than GaN.

4. The method of forming the vertical GaN transistor with the insulating channel of claim 3,
wherein residual donors in the channel insulating GaN layer (3) are compensated in a way that the concentration of free electrons in the channel insulating layer is less or equal than 10¹¹ cm⁻³.

## Patentansprüche

1. Vertikaler GaN-Transistor mit einer isolierenden Kanalschicht, der von unten beginnend mindestens umfasst:
(a) ein leitfähiges GaN-Substrat (1);
(b) eine auf dem leitfähigen GaN-Substrat (1) ausgebildete n-GaN-Driftschicht (2);
(c) eine auf der n-GaN-Driftschicht (2) ausgebildete zylindrische isolierende GaN-Kanalschicht (3), wobei Restdonatoren durch Zugabe oder Erhöhung der Konzentration von Kohlenstoff C kompensiert sind, wobei die Konzentration von Kohlenstoffverunreinigungen in der isolierenden GaN-Kanalschicht (3) im Bereich von 10¹⁶ cm⁻³ bis 10¹⁸ cm⁻³ liegt;
(d) eine n⁺ GaN-Kontaktschicht (4), die auf der isolierenden GaN-Kanalschicht (3) ausgebildet ist; wobei eine Source-Elektrode (6) auf der Oberseite der n⁺-GaN-Kontaktschicht (4) angeordnet ist, eine Drain-Elektrode (7) an der Rückseite des GaN-Substrats (1) angeordnet ist und eine Gate-Elektrode (8) vertikal entlang der isolierenden GaN-Kanalschicht (3) angeordnet ist und über ihre gesamte Länge von der n⁺-GaN-Kontaktschicht (4), der isolierenden GaN-Kanalschicht (3) und der n-GaN-Driftschicht (2) durch eine dielektrische Isolierschicht (5) mit einer größeren Bandlücke als GaN getrennt ist.

2. Vertikaler GaN-Transistor mit der isolierenden Kanalschicht nach Anspruch 1, wobei die Konzentration freier Elektronen in der isolierenden Kanalschicht kleiner als oder gleich 10¹¹ cm⁻³ ist.

3. Verfahren zur Herstellung eines vertikalen GaN-Transistors mit einer isolierenden Kanalschicht, wobei das Verfahren nacheinander mindestens umfasst:
(a) Ausbilden einer n-GaN-Driftschicht (2) durch Aufwachsen auf einem leitfähigen GaN-Substrat (1);
(b) Ausbilden der zylindrischen isolierenden GaN-Kanalschicht (3) durch Aufwachsen, wobei Restdonatoren durch Zugabe oder Erhöhung der Konzentration von Kohlenstoff C kompensiert werden, wobei die Konzentration von Kohlenstoffverunreinigungen in der isolierenden GaN-Kanalschicht (3) im Bereich von 10¹⁶ cm⁻³ bis 10¹⁸ cm⁻³ liegt, um eine spezifische Konzentration freier Elektronen in der isolierenden GaN-Kanalschicht (3) nach dem Ausbilden der n-GaN-Driftschicht (2) zu erreichen;
(c) Ausbilden einer n⁺-GaN-Kontaktschicht (4) durch Aufwachsen nach dem Ausbilden der isolierenden GaN-Kanalschicht (3);
und nachfolgendes Ausbilden einer Source-Elektrode (6), die auf der Oberseite der ausgebildeten n⁺-GaN-Kontaktschicht (4) angeordnet ist, einer Drain-Elektrode (7), die an der Rückseite des GaN-Substrats (1) angeordnet ist, und einer Gate-Elektrode (8), die vertikal entlang der ausgebildeten isolierenden GaN-Kanalschicht (3) angeordnet ist und über ihre gesamte Länge von der n⁺-GaN-Kontaktschicht (4), der isolierenden GaN-Kanalschicht (3) und der n-GaN-Driftschicht (2) durch eine dielektrische Isolierschicht (5) mit einer größeren Bandlücke als GaN getrennt ist.

4. Verfahren zur Herstellung des vertikalen GaN-Transistors mit der isolierenden Kanalschicht nach Anspruch 3, wobei Restdonatoren in der isolierenden GaN-Kanalschicht (3) derart kompensiert werden, dass die Konzentration freier Elektronen in der isolierenden GaN-Kanalschicht kleiner als oder gleich 10" cm⁻³ ist.

## Revendications

1. Transistor vertical en GaN doté d'une couche isolante de canal, comprenant à partir du bas au moins :
(a) un substrat conducteur en GaN (1) ;
(b) une couche de dérive en GaN de type n (2) formée sur le substrat conducteur en GaN (1) ;
(c) une couche isolante de canal cylindrique en GaN (3) formée sur la couche de dérive en GaN de type n (2), dans laquelle des donneurs résiduels sont compensés par l'ajout ou l'augmentation de la concentration en carbone C, dans laquelle la concentration des impuretés de carbone dans la couche isolante de canal en GaN (3) est comprise dans la plage de 10¹⁶ cm⁻³ à 10¹⁸ cm⁻³ ;
(d) une couche de contact en GaN de type n+ (4) formée sur la couche isolante de canal en GaN (3) ; dans lequel une électrode de source (6) est située sur le dessus de la couche de contact en GaN de type n+ (4), une électrode de drain (7) est située sur la face arrière du substrat en GaN (1), et une électrode de grille (8) est située verticalement le long de la couche isolante de canal en GaN (3) et est séparée sur toute sa longueur de la couche de contact en GaN de type n+ (4), de la couche isolante de canal (3) et de la couche de dérive en GaN de type n (2) par une couche isolante diélectrique (5) présentant une bande interdite plus large que celle du GaN.

2. Transistor vertical en GaN à canal isolant selon la revendication 1, dans lequel la concentration d'électrons libres dans la couche isolante de canal est inférieure ou égale à 10¹¹ cm⁻³.

3. Procédé de formation d'un transistor vertical en GaN doté d'une couche isolante de canal, le procédé comprenant séquentiellement au moins :
(a) la formation par croissance d'une couche de dérive en GaN de type n (2) sur un substrat conducteur en GaN (1) ;
(b) la formation par croissance de la couche isolante de canal cylindrique en GaN (3), dans laquelle des donneurs résiduels sont compensés par l'ajout ou l'augmentation de la concentration en carbone C, moyennant quoi la concentration des impuretés de carbone dans la couche isolante de canal en GaN (3) est comprise dans la plage de 10¹⁶ cm⁻³ à 10¹⁸ cm⁻³ afin d'atteindre une concentration spécifique d'électrons libres dans la couche isolante de canal en GaN (3) après la formation de la couche de dérive en GaN de type n (2) ;
(c) la formation par croissance d'une couche de contact en GaN de type n+ (4), après la formation de la couche isolante de canal (3) ;
et la formation consécutive d'une électrode de source (6) située sur le dessus de la couche de contact en GaN de type n+ formée (4), d'une électrode de drain (7) située sur la face arrière du substrat en GaN (1), et d'une électrode de grille (8) située verticalement le long de la couche isolante de canal en GaN formée (3), séparée sur toute sa longueur de la couche de contact en GaN de type n+ (4), de la couche isolante de canal (3) et de la couche de dérive en GaN de type n (2) par une couche isolante diélectrique (5) présentant une bande interdite plus large que celle du GaN.

4. Procédé de formation d'un transistor vertical en GaN à canal isolant selon la revendication 3, dans lequel les donneurs résiduels dans la couche isolante de canal en GaN (3) sont compensés de manière à ce que la concentration d'électrons libres dans la couche isolante de canal soit inférieure ou égale à 10¹¹ cm⁻³.
